# EUROPEAN PATENT APPLICATION

(11) **EP 4 417 652 A1**
(43) Date of publication of application: **21.08.2024**
(21) Application number: 21960627.4
(22) Date of filing: 14.10.2021
(51) Int. Cl.: C08L 101/00, B32B 27/30, C08J 5/18, H05K 1/03

(54) **RESIN SHEET, LAMINATED BOARD, METAL-CLAD LAMINATED BOARD, PRINTED WIRING BOARD, AND SEMICONDUCTOR PACKAGE**

(71) Applicant: Resonac Corporation, Tokyo 105-7325 (JP)
(72) Inventor: SERA, Yusuke, Tokyo 100-6606 (JP); ABE, Shinichiro, Tokyo 100-6606 (JP); HASEGAWA, Yasuharu, Tokyo 100-6606 (JP); KOTAKE, Tomohiko, Tokyo 100-6606 (JP); FUJIMOTO, Daisuke, Tokyo 100-6606 (JP)
(74) Representative: Hoffmann Eitle
(86) International application number: PCT/JP2021/038025
(87) International publication number: WO 2023/062769

(57) **Abstract**

Provided is a resin sheet containing a resin component (A) and an inorganic filler (B), the component (A) containing an elastomer (A1) having a number average molecular weight of 10,000 or more, having a content of the component (A1) of 30% by mass or more based on the component (A), the resin sheet having a content of the component (B) of 40 to 95% by volume based on the total amount of the resin sheet.

## Description

### Technical Field

The present disclosure relates to a resin sheet, a laminated board, a metal-clad laminated board, a printed wiring board, and a semiconductor package.

### Background Art

The speed and capacity of signals used in mobile communication devices represented by mobile phones, base station equipment therefor, servers, network infrastructure devices, such as routers, large computers, and the like are increasing year by year. In accordance with the trends, the printed wiring boards installed in the electronic devices are demanded to be compatible with high frequencies, and there is a demand of a board material that is excellent in dielectric characteristics in a high frequency band capable of reducing the transmission loss, i.e., that has a small dielectric constant (Dk) and a small dielectric loss tangent (Df).

On the other hand, the size reduction of electronic devices promotes increase of the mounting density of electronic components used in a printed wiring board. A PGA (pin grid array) type package has been used for the increase of the mounting density. The PGA type package has a structure including pins that protrude from the back surface of the board in the perpendicular direction in a grid pattern with regular intervals. The size of the pins, the intervals of the pins, and the like are often fixed, and changing the design thereof is often difficult. In the case where the dielectric constant of the board material is decreased, it is necessary to reduce the size of the pins of the PGA type package, and to reduce the intervals of the pins thereof, but the dielectric constant of the board material is necessarily held at the desired value since the changing the design thereof is difficult as described above. In other words, for simultaneously achieving both the increase of the mounting density and the compatibility with high frequencies, it is necessary to reduce the dielectric loss tangent of the board material while retaining the dielectric constant thereof to the desired value, and there is a strong demand for the material manufacturers to develop such a board material.

A board material capable of achieving a low transmission loss, a prepreg using a thermosetting resin composition excellent in dielectric characteristics in a high frequency band has been developed (see, for example, PTL 1). A prepreg is constituted by a reinforcement and a thermosetting resin composition, and the presence of the reinforcement enables the handling of the prepreg without a support medium.

### Citation List

### Patent Literature

PTL 1: JP2020-169276A

### Summary of Invention

### Technical Problem

However, a glass cloth, which is one representative example of the reinforcement, is produced by knitting glass strands obtained by bundling and twisting multiple glass filaments in the presence of a sizing agent, and generally contains impurities (e.g., B₂O₃, CaO, MgO, and Na₂O) derived from the glass components other than SiO₂, and impurities, such as the sizing agent. As a result of the investigations by the present inventors, it has been found that the impurities deteriorate the dielectric characteristics, and thus limit the capability to meet the recent high improvement requirement for the dielectric loss tangent (Df). Based on the knowledge, a simple resin sheet without the use of a glass cloth in the ordinary prepreg has been investigated, but there are problems that the resin sheet is broken off or shattered unless a support medium, such as a polyethylene terephthalate (PET) film, is attached thereto, and the low thermal expansion thereof is also impaired.

In view of the circumstances described above, an object of the present disclosure is to provide a resin sheet that can be handled without the use of a support medium, has the low thermal expansion, and has a dielectric constant (Dk) in a high frequency band of a 10 GHz band or higher of 2.65 to 3.30 and a dielectric loss tangent (Df) in a high frequency band of a 10 GHz band or higher of 0.00097 or less. Another object thereof is to provide a laminated board, a printed wiring board, and a semiconductor package, produced by using the resin sheet.

### Solution to Problem

As a result of investigations performed by the present inventors for achieving the objects, it has been found that the objects can be achieved by the present disclosure.

The present disclosure includes the following items [1] to [12].
[1] A resin sheet containing a resin component (A) and an inorganic filler (B),
   the component (A) containing an elastomer (A1) having a number average molecular weight of 10,000 or more, having a content of the component (A1) of 30% by mass or more based on the component (A),
   the resin sheet having a content of the component (B) of 40 to 95% by volume based on the total amount of the resin sheet.
[2] The resin sheet according to the item [1], in which the resin sheet has a content of the component (B) of 60 to 95% by volume based on the total amount of the resin sheet.
[3] The resin sheet according to the item [1] or [2], in which the resin sheet further contains an elastomer (A2) having a number average molecular weight of less than 10,000.
[4] The resin sheet according to any of the items [1] to [3], in which the component (A) further contains a thermosetting resin (A3).
[5] The resin sheet according to the item [4], in which the component (A) has a total content of the component (A1) and the component (A2) of 60 to 95% by mass based on the component (A).
[6] The resin sheet according to any of the items [1] to [5], in which the resin sheet contains no organic solvent, or contains an organic solvent in a content thereof of less than 1% by mass based on the total amount of the resin sheet.
[7] The resin sheet according to any of the items [1] to [6], in which the resin sheet contains no glass fiber, or contains glass fibers in a content thereof of 10% by volume or less based on the total amount of the resin sheet.
[8] The resin sheet according to any of the items [1] to [7], in which the component (A1) contains one or more kinds selected from the group consisting of a styrene based elastomer, an olefin based elastomer, a urethane based elastomer, a polyester based elastomer, a polyamide based elastomer, an acrylic based elastomer, a silicone based elastomer, and derivatives thereof.
[9] A laminated board including a cured product of the resin sheet according to any of the items [1] to [8].
[10] A metal-clad laminated board including a metal foil and a cured product of the resin sheet according to any of the items [1] to [8].
[11] A printed wiring board including the laminated board according to the item [9] or the metal-clad laminated board according to the item [10].
[12] A semiconductor package including the printed wiring board according to the item [11] and a semiconductor device.

### Advantageous Effects of Invention

The present disclosure can provide a resin sheet that can be handled without the use of a support medium, has the low thermal expansion, and has a dielectric constant (Dk) in a high frequency band of a 10 GHz band or higher of 2.65 to 3.30 and a dielectric loss tangent (Df) in a high frequency band of a 10 GHz band or higher of 0.00097 or less, and also can provide a laminated board, a printed wiring board, and a semiconductor package, produced by using the resin sheet.

### Brief Description of Drawings

Fig. 1 is a photograph showing the state where the self-standing capability is evaluated in Example 3.
Fig. 2 is a photograph showing the state where the self-standing capability is evaluated in Comparative Example 1 (provided that, it is a state that the resin sheet after the evaluation is inverted so as to place the resin sheet facing upward).

### Description of Embodiments

In the numerical ranges described in the description herein, the upper limit values and the lower limit values of the numerical ranges can be replaced by the values shown in the examples. The lower limit value and the upper limit value of the numerical range can be optionally combined with the lower limit values and the upper limit values of the other numerical ranges, respectively. In the expression of a numerical range of "AA to BB", the numerical values at both ends AA and BB are included in the numerical range as the lower limit value and the upper limit value, respectively.

In the description herein, for example, the expression "10 or more" means 10 and values exceeding 10, which is applied to other values, and for example, the expression "10 or less" means 10 and values less than 10, which is applied to other values.

One kind of each of the components and the materials exemplified in the description herein may be used alone, or two or more kinds thereof may be used in combination, unless otherwise indicated. In the description herein, in the case where multiple substances exist for each of the components in the composition, the content of each of the components in the composition means the total amount of the multiple substances existing in the composition, unless otherwise indicated.

In the description herein, the "solid content" means components in the resin composition other than volatile substances, such as water and an organic solvent. Accordingly, the solid content encompasses materials in a liquid form, a viscous form, or a wax form around 25°C, and does not necessarily mean a solid matter.

In the description herein, the "dielectric constant" and the "dielectric loss tangent" mean the "dielectric constant" and the "dielectric loss tangent" in a 10 GHz band, respectively, unless otherwise indicated. In the description herein, the dielectric constant and the dielectric loss tangent may be generically referred to as "dielectric characteristics".

Embodiments obtained by combining the matters described in the description herein are also encompassed in the present disclosure and the present embodiment.

### [Resin Sheet]

One embodiment of the present embodiment is a resin sheet shown below:
a resin sheet containing a resin component (A) and an inorganic filler (B),
the component (A) containing an elastomer (A1) having a number average molecular weight of 10,000 or more, having a content of the component (A1) of 30% by mass or more based on the component (A),
the resin sheet having a content of the component (B) of 40 to 95% by volume based on the total amount of the resin sheet.

The expression "resin sheet containing AA" herein encompasses both a resin sheet containing the components listed in AA as they are, and a resin sheet obtained by reacting at least a part of the components listed in AA.

The resin sheet of the present embodiment can be handled without the use of a support medium, has the low thermal expansion, and has a dielectric constant (Dk) in a high frequency band of a 10 GHz band or higher of 2.65 to 3.30 and a dielectric loss tangent (Df) in a high frequency band of a 10 GHz band or higher of 0.00097 or less.

The dielectric constant (Dk) is preferably 2.80 to 3.30, more preferably 2.85 to 3.25, and further preferably 2.90 to 3.16.

The dielectric loss tangent (Df) is preferably 0.00095 or less, more preferably 0.00090 or less, further preferably 0.00080 or less, particularly preferably 0.00075 or less, and most preferably 0.00070 or less. The lower limit value of the dielectric loss tangent (Df) is not particularly limited, may be 0.00030 or more may be 0.00035 or more, may be 0.00040 or more, and may be 0.00045 or more.

The dielectric constant (Dk) and the dielectric loss tangent (Df) are values that are measured by using a split post dielectric resonator (SPDR), and in more detail, are values that are measured by the method shown in the examples.

One preferred embodiment of the resin sheet of the present embodiment contains no organic solvent, or contains an organic solvent in a content thereof of less than 1% by mass based on the total amount of the resin sheet, and nevertheless the resin sheet is less likely to suffer cracks or the like and is excellent in handleability due to the sufficient flexibility thereof. One preferred embodiment of the resin sheet of the present embodiment has an advantage that voids are less likely to occur in a reflow process due to the small content of an organic solvent thereof.

The content of an organic solvent in the resin sheet is a value that is measured by the method shown in the examples.

One preferred embodiment of the resin sheet of the present embodiment contains no glass fiber, or contains glass fibers in a content thereof of 10% by volume or less based on the total amount of the resin sheet (which may be hereinafter referred to as a "feature A"), from the standpoint of the dielectric loss tangent (Df), and nevertheless the resin sheet can be handled without the use of a support medium (which may be hereinafter referred to as a "self-standing capability"). In the case where the resin sheet contains glass fibers, the content thereof is preferably 7% by volume or less, more preferably 5% by volume or less, and further preferably 3% by volume or less, based on the total amount of the resin sheet, from the standpoint of the dielectric loss tangent (Df).

In the description for the feature A in one embodiment described above, the term "glass fibers" can be replaced by a "glass cloth", and can also be replaced by a "fiber substrate". Accordingly, another preferred embodiment of the resin sheet of the present embodiment contains no glass cloth, or contains a glass cloth in a content thereof of 10% by volume or less based on the total amount of the resin sheet, from the standpoint of the dielectric loss tangent (Df). Still another preferred embodiment of the resin sheet of the present embodiment contains no fiber substrate, or contains a fiber substrate in a content thereof of 10% by volume or less based on the total amount of the resin sheet, from the standpoint of the dielectric loss tangent (Df). In the case where the resin sheet of the present embodiment contains a glass cloth or a fiber substrate, the preferred content thereof is the same as in the case of glass fibers described above.

The components contained in the resin sheet of the present embodiment will be described in detail below.

### (Resin Component (A), Elastomer (A1) having Number Average Molecular Weight of 10,000 or more)

The resin sheet of the present embodiment contains a resin component as a component (A), the component (A) contains an elastomer (A1) having a number average molecular weight of 10,000 or more, and the content of the component (A1) is 30% by mass or more based on the component (A).

The resin sheet of the present embodiment shows the sufficient self-standing capability and thus can have the feature A described above since the component (A1) is contained therein in the prescribed amount or more. As a result, the resin sheet of the present embodiment shows the sufficient flexibility. Furthermore, the resin sheet of the present embodiment can have the prescribed dielectric constant (Dk) and the prescribed dielectric loss tangent (Df) described above.

The number average molecular weight (Mn) of the component (A1) is preferably 15,000 or more, and more preferably 18,000 or more, from the standpoint of the self-standing capability. The upper limit value of the number average molecular weight of the component (A1) is not particularly limited, may be 300,000 or less, may be 250,000 or less, may be 220,000 or less, and may be 180,000 or less. The number average molecular weight of the component (A1) may be 10,000 or more and less than 100,000, may be 10,000 to 50,000, may be 100,000 to 300,000, and may be 130,000 to 230,000.

In the description herein, the number average molecular weight is a value that is obtained in terms of polystyrene conversion by the gel permeation chromatography (GPC) method using tetrahydrofuran as a solvent.

The content of the component (A1) is 30% by mass or more, i.e., 30 to 100% by mass, preferably 30 to 90% by mass, more preferably 30 to 80% by mass, further preferably 35 to 70% by mass, particularly preferably 40 to 65% by mass, and most preferably 40 to 60% by mass, based on the component (A). In the case where the content of the component (A1) is the lower limit value or more, the resin sheet can have the self-standing capability, and simultaneously can have the prescribed dielectric constant (Dk) and the prescribed dielectric loss tangent (Df) described above.

The component (A1) preferably contains one or more kinds selected from the group consisting of a styrene based elastomer, an olefin based elastomer, a urethane based elastomer, a polyester based elastomer, a polyamide based elastomer, an acrylic based elastomer, a silicone based elastomer, and derivatives thereof. Among these, a styrene based elastomer and a maleimide based elastomer from the standpoint of achieving the prescribed dielectric constant (Dk) and the prescribed dielectric loss tangent (Df) described above, while not particularly limited. All the elastomers used may be commercially available products.

Examples of the derivatives of the elastomers include the elastomer that has a reactive functional group at the molecular end or in the molecular chain thereof. Examples of the reactive functional group include an acid anhydride group, an epoxy group, a hydroxy group, a carboxy group, an amino group, an amide group, an isocyanate group, an acrylic group, a methacrylic group, and a vinyl group.

### (Styrene based Elastomer, Component (A1))

Examples of the styrene based elastomer include a styrene-butadiene copolymer, such as a styrene-butadiene diblock copolymer and a styrene-butadiene-styrene triblock copolymer; a styrene-isoprene copolymer, such as a styrene-isoprene diblock copolymer and a styrene-isoprene-styrene triblock copolymer; a hydrogenated product of the styrene-butadiene copolymer; and a hydrogenated product of the styrene-isoprene copolymer, while not particularly limited. The copolymers each may contain or may not contain a structural unit derived from a vinyl group-containing aromatic compound, such as divinylbenzene.

One kind of the styrene based elastomer may be used alone, or two or more kinds thereof may be used in combination.

The number average molecular weight (Mn) of the styrene based elastomer is the same as the number average molecular weight (Mn) of the component (A1), is preferably 100,000 to 300,000, may be 130,000 to 230,000, may be 140,000 to 200,000, and may be 140,000 to 170,000.

The styrene content ratio of the styrene based elastomer is preferably 10 to 70% by mass, more preferably 10 to 50% by mass, and further preferably 10 to 30% by mass, while not particularly limited. The styrene content ratio herein means the content ratio of the styrene structural unit based on the total structural units. The styrene content ratio that is the lower limit value or more leads to a tendency of providing the good heat resistance, and that is the upper limit value or less leads to a tendency of providing the excellent rubber elasticity and the good self-standing capability and flexibility.

The styrene based elastomer may be an unhydrogenated product or a hydrogenated product. In the case where the styrene based elastomer is a hydrogenated product, the hydrogenation degree thereof is preferably 80 to 100% by mol, more preferably 85 to 100% by mol, further preferably 90 to 100% by mol, and may be 95 to 100% by mol, while not particularly limited.

The styrene based elastomer used may be a commercially available product. Examples of the commercially available product include "Tufprene (registered trademark)", "Asaprene (registered trademark) T", "Tuftec (registered trademark) H1043", "Tuftec (registered trademark) MP10", "Tuftec (registered trademark) H1221", "Tuftec (registered trademark) M1911", and "Tuftec (registered trademark) M1913" (all available from Asahi-Kasei Chemicals Corporation), "Epofriend (registered trademark) AT501" and Epofriend (registered trademark) CT310" (all available from Daicel Corporation), and "Septon (registered trademark) 2063" (available from Kuraray Co., Ltd.).

### (Maleimide based Elastomer, Component (A1))

The maleimide based elastomer is not particularly limited, as far as being an elastomer having a maleimide skeleton, and examples thereof include a maleimide compound having a structure including a saturated or unsaturated aliphatic hydrocarbon group bonded to the maleimide group. The maleimide compound having a structure including a saturated or unsaturated aliphatic hydrocarbon group bonded to the maleimide group is preferably a maleimide compound having a structure including a saturated or unsaturated aliphatic hydrocarbon group bonded to the nitrogen atom of the maleimide group.

The maleimide compound having a structure including a saturated or unsaturated aliphatic hydrocarbon group bonded to the maleimide group preferably has at least two maleimide groups, and is more preferably a maleimide compound having one or more of a structure represented by the following general formula (1), and further preferably a maleimide compound represented by the following general formula (2).

The number of carbon atoms of the saturated or unsaturated aliphatic hydrocarbon group is preferably 1 to 100, more preferably 2 to 50, and further preferably 4 to 40. The number of carbon atoms of the saturated or unsaturated aliphatic hydrocarbon group may be 8 to 100, may be 8 to 50, may be 15 to 50, may be 25 to 50, and may be 30 to 45. The saturated or unsaturated aliphatic hydrocarbon group may be any of a linear group, a branched group, and a cyclic group, and may be a combination thereof. The cyclic group is preferably an alicyclic hydrocarbon group. The saturated or unsaturated aliphatic hydrocarbon group is preferably a combination of a linear group and a cyclic group, and more preferably a combination of a linear group and an alicyclic hydrocarbon group.

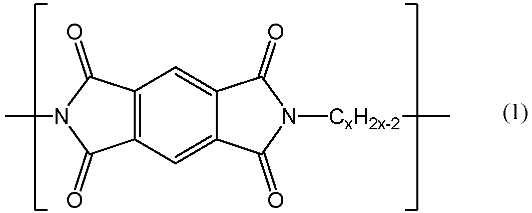

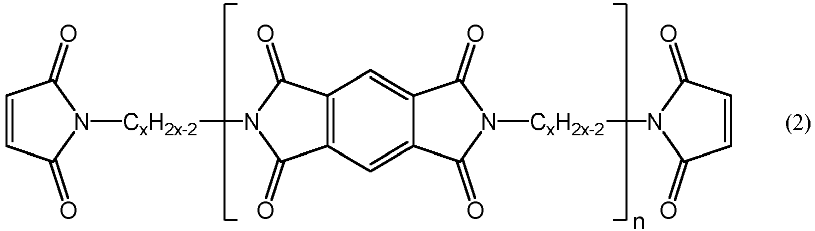

In the general formula (1) and the general formula (2), x represents an integer of 10 to 50, and preferably an integer of 20 to 40. In the general formula (2), n shows the number of the structural unit enclosed in the bracket, and preferably represents an integer of 0 to 50, more preferably an integer of 1 to 30, further preferably an integer of 1 to 20, and particularly preferably an integer of 1 to 10.

Specific examples of the maleimide compound represented by the general formula (2) include a compound represented by the following formula (3). In the following formula (3), n shows the number of the structural unit enclosed in the parentheses, and represents an integer of 1 to 10.

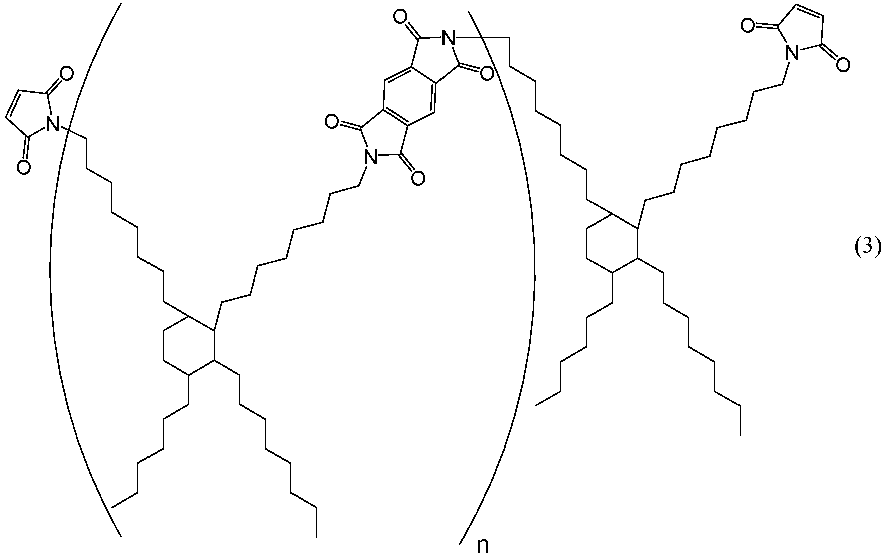

The number average molecular weight (Mn) of the maleimide based elastomer is the same as the number average molecular weight (Mn) of the component (A1), is preferably 10,000 or more and less than 100,000, may be 10,000 to 50,000, may be 15,000 to 35,000, and may be 17,000 to 30,000.

### (Elastomer (A2) having Number Average Molecular Weight of less than 10,000)

The component (A) may contain an elastomer other than the elastomer (A1) having a number average molecular weight of 10,000 or more, i.e., an elastomer (A2) having a number average molecular weight of less than 10,000. The component (A2) has an effect of enhancing the compatibility between the component (A1) and a thermosetting resin (A3) described later.

The number average molecular weight (Mn) of the component (A2) is preferably 300 or more and less than 10,000, and more preferably 400 to 9,000, may be 500 to 6,000, may be 500 to 4,000, may be 500 to 2,500, may be 700 to 2,500, and may be 850 to 2,000, from the standpoint of enhancing the compatibility between the component (A1) and a thermosetting resin (A3) described later.

Examples of the component (A2) include the same materials as the component (A1), and among these, a polybutadiene based elastomer and a styrene based elastomer are preferred from the standpoint of enhancing the compatibility between the component (A1) and a thermosetting resin (A3) described later, and the standpoint of the dielectric constant (Dk) and the dielectric loss tangent (Df).

### (Polybutadiene based Elastomer, Component (A2))

Examples of the polybutadiene based elastomer include polybutadienediol, polybutadienedicarboxylic acid, maleated polybutadiene, a butadiene homopolymer, a copolymer copolymerizable with butadiene, a compound obtained by reacting polybutadienediol and a compound having an isocyanate group, a compound obtained by reacting polybutadienediol and a compound having a carboxy group, a compound obtained by reacting polybutadienedicarboxylic acid and a compound having a hydroxy group, and a compound obtained by reacting polybutadienedicarboxylic acid and a compound having an epoxy group. Among these, the polybutadiene based elastomer is preferably a butadiene homopolymer.

The number average molecular weight (Mn) of the polybutadiene based elastomer used as the component (A2) is less than 10,000, preferably 300 or more and less than 10,000, and more preferably 400 to 9,000, may be 500 to 6,000, may be 500 to 4,000, may be 500 to 2,500, may be 700 to 2,500, and may be 850 to 2,000.

The polybutadiene based elastomer used may be a commercially available product.

Examples of the commercially available product of the polybutadienedicarboxylic acid include C-1000 (content ratio of 1,2-structural unit: 85% or more, trade name, available from Nippon Soda Co., Ltd.).

Examples of the commercially available product of the butadiene homopolymer include B-1000 (content ratio of 1,2-structural unit: 85%), B-2000 (content ratio of 1,2-structural unit: 85%), and B-3000 (content ratio of 1,2-structural unit: 90%) (all trade names, available from Nippon Soda Co., Ltd.).

Examples of the commercially available product of the compound obtained by reacting polybutadienediol and a compound having an isocyanate group include TEAI-1000 and TE-2000 (all trade names, available from Nippon Soda Co., Ltd.).

Examples of the commercially available product of the compound obtained by reacting polybutadienedicarboxylic acid and a compound having an epoxy group include EPB13 (trade name, available from Nippon Soda Co., Ltd.).

### (Styrene based Elastomer, Component (A2))

Examples of the styrene based elastomer include the same materials as in the styrene based elastomer for the component (A1). However, the number average molecular weight (Mn) of the styrene based elastomer used as the component (A2) is less than 10,000, may be 3,000 to 9,500, may be 5,000 to 9,500, may be 7,000 to 9,500, and may be 7,500 to 9,500.

The styrene based elastomer used may be a commercially available product.

The total content of the component (A1) and the component (A2) is preferably 60 to 95% by mass, more preferably 70 to 95% by mass, further preferably 75 to 95% by mass, particularly preferably 75 to 90% by mass, and most preferably 75 to 85% by mass, based on the component (A). In the case where the total content of the component (A1) and the component (A2) is the lower limit value or more, the elastomer becomes a major component of the resin sheet, resulting in a tendency that the dielectric loss tangent (Df) is sufficiently low, and the resin sheet has the sufficient flexibility. In the case where the total content of the component (A1) and the component (A2) is the upper limit value or less, the thermosetting resin (A3) described later can be sufficiently contained, resulting in a tendency that the resin sheet can be easily imparted with various characteristics, such as the low thermal expansion, the heat resistance, and the adhesiveness to a conductor.

### (Thermosetting Resin (A3))

The component (A) may further contain a thermosetting resin as a component (A3). The thermosetting resin contained can enhance the heat resistance of the resin sheet. One kind of the component (A3) may be used alone, or two or more kinds thereof may be used in combination.

Examples of the thermosetting resin include an epoxy resin, a phenol resin, an unsaturated imide resin, a cyanate resin, an isocyanate, resin, a benzoxazine resin, an oxetane resin, an amino resin, an unsaturated polyester resin, an allyl resin, a dicyclopentadiene resin, a silicone resin, a triazine resin, and a melamine resin. The thermosetting resin is not particularly limited to these, and known thermosetting resins can be used. Among these, an unsaturated imide resin is preferred from the standpoint of the low thermal expansion and the heat resistance, and the standpoint of the adhesiveness to a conductor.

The unsaturated imide resin is preferably a maleimide compound from the standpoint of the low thermal expansion and the heat resistance, and the standpoint of the adhesiveness to a conductor. Examples of the maleimide compound include one or more kinds selected from the group consisting of a maleimide compound having one or more N-substituted maleimide groups, and a derivative thereof. The maleimide compound herein does not include the maleimide based elastomer described above.

Examples of the derivative of a maleimide compound having one or more N-substituted maleimide groups include an addition reaction product of the maleimide compound having one or more N-substituted maleimide groups and an amine compound, such as a diamine compound.

The maleimide compound is preferably one or more kinds selected from the group consisting of a maleimide compound having one or more N-substituted maleimide groups, and an aminomaleimide compound having a structural unit derived from a maleimide compound and a structural unit derived from a diamine compound, from the standpoint of the low thermal expansion and the heat resistance, and the standpoint of the adhesiveness to a conductor.

Examples of the maleimide compound having one or more N-substituted maleimide groups include an aromatic maleimide compound having one N-substituted maleimide group in the molecule, such as N-phenylmaleimide, N-(2-methylphenyl)maleimide, N-(4-methylphenyl)maleimide, N-(2,6-dimethylphenyl)maleimide, N-(2,6-diethylphenyl)maleimide, N-(2-methoxyphenyl)maleimide, N-benzylmaleimide, N-dodecylmaleimide, N-isopropylmaleimide, and N-cyclohexylmaleimide; an aromatic bismaleimide compound having two N-substituted maleimide groups in the molecule, such as bis(4-maleimidophenyl)methane, bis(4-maleimidophenyl) ether, bis(4-maleimidophenyl)sulfone, 3,3'-dimethyl-5,5'-diethyl-4,4'-diphenylmethane bismaleimide, 4-methyl-1,3-phenylene bismaleimide, m-phenylene bismaleimide, and 2,2-bis(4-(4-maleimidophenoxy)phenyl)propane; an aromatic maleimide compound having three or more N-substituted maleimide groups in the molecule, such as polyphenylmethane maleimide and biphenylaralkyl type maleimide; and an aliphatic maleimide compound, such as 1,6-bismaleimido(2,2,4-trimethyl)hexane and pyrophosphoric acid binder type long-chain alkyl bismaleimide.

Examples of the structural unit derived from a maleimide compound that the aminomaleimide compound has include a structural unit derived from the maleimide compound having one or more N-substituted maleimide groups described above.

The structural unit derived from a diamine compound that the aminomaleimide compound has is the same as the structural unit derived from the diamine compound described later.

In the present embodiment, the maleimide compound is preferably one or more kinds of a compound selected from the group consisting of the following items (i) and (ii) from the standpoint of the dielectric characteristics, the low thermal expansion, and the heat resistance, and the standpoint of the adhesiveness to a conductor, while not particularly limited thereto.
(i) A maleimide compound (x1) containing a condensed ring of an aromatic ring and an aliphatic ring in the molecular structure thereof, having two or more N-substituted maleimide groups (which may be hereinafter referred to as a "maleimide compound (x1)" or a "component (x1)")
(ii) An aminomaleimide compound having a structural unit derived from the maleimide compound (x1) and a structural unit derived from the diamine compound (x2) (which may be hereinafter referred to as an "aminomaleimide compound (X1)")

The one or more kinds of a compound selected from the group consisting of the items (i) and (ii) will be described in detail below.

### (Maleimide Compound (x1))

The component (x1) is preferably an aromatic maleimide compound containing a condensed ring of an aromatic ring and an aliphatic ring in the molecular structure thereof, having two or more N-substituted maleimide groups that are directly bonded to the aromatic group, and more preferably an aromatic bismaleimide compound containing a condensed ring of an aromatic ring and an aliphatic ring in the molecular structure thereof, having two N-substituted maleimide groups that are directly bonded to the aromatic group, from the standpoint of the dielectric characteristics, the low thermal expansion, and the heat resistance, and the standpoint of the adhesiveness to a conductor.

The condensed ring contained in the component (x1) preferably has a condensed bicyclic ring, and more preferably is an indane ring, from the standpoint of the dielectric characteristics, the low thermal expansion, and the heat resistance, the standpoint of the adhesiveness to a conductor, and the standpoint of the manufacturability.

In the description herein, the indane ring means a condensed bicyclic structure of an aromatic 6-membered ring and a saturated aliphatic 5-membered ring. At least one carbon atom in the ring-forming carbon atoms forming the indane ring has a bonding group for bonding to another group constituting the component (x1). The ring-forming carbon atom having the bonding group and the other ring-forming carbon atoms each may have or may not have a bonding group, a substituent, and the like other than the bonding group.

In the component (x1), the indane ring is preferably contained in the form of a divalent group represented by the following general formula (x1-1): 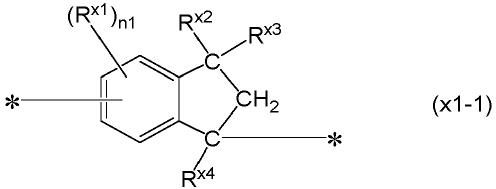 in which R^{x1} represents an alkyl group having 1 to 10 carbon atoms, an alkoxy group having 1 to 10 carbon atoms, an alkylthio group having 1 to 10 carbon atoms, an aryl group having 6 to 10 carbon atoms, an aryloxy group having 6 to 10 carbon atoms, an arylthio group having 6 to 10 carbon atoms, a cycloalkyl group having 3 to 10 carbon atoms, a halogen atom, a hydroxy group, or a mercapto group, n1 represents an integer of 0 to 3, R^{x2} to R^{x4} each independently represent an alkyl group having 1 to 10 carbon atoms, and * represents a bonding site.

Examples of the alkyl group having 1 to 10 carbon atoms represented by R^{x1} in the general formula (x1-1) include a methyl group, an ethyl group, a propyl group, a butyl group, a pentyl group, a hexyl group, a heptyl group, an octyl group, and a decyl group. The alkyl groups each may be linear or branched.

Examples of the alkyl group contained in the alkoxy group having 1 to 10 carbon atoms and the alkylthio group having 1 to 10 carbon atoms represented by R^{x1} include the same groups as for the alkyl group having 1 to 10 carbon atoms.

Examples of the aryl group having 6 to 10 carbon atoms represented by R^{x1} include a phenyl group and a naphthyl group.

Examples of the aryl group contained in the aryloxy group having 6 to 10 carbon atoms and the arylthio group having 6 to 10 carbon atoms represented by R^{x1} include the same groups as for the aryl group having 6 to 10 carbon atoms.

Examples of the cycloalkyl group having 3 to 10 carbon atoms represented by R^{x1} include a cyclopropyl group, a cyclobutyl group, a cyclopentyl group, a cyclohexyl group, a cycloheptyl group , a cyclooctyl group, and a cyclodecyl group.

In the case where n1 in the general formula (x1-1) is 1 to 3, R^{x1} preferably represents an alkyl group having 1 to 4 carbon atoms, a cycloalkyl group having 3 to 6 carbon atoms, or an aryl group having 6 to 10 carbon atoms, and more preferably represents an alkyl group having 1 to 4 carbon atoms, from the standpoint of the solubility in an organic solvent and the reactivity.

Examples of the alkyl group having 1 to 10 carbon atoms represented by R^{x2} to R^{x4} include a methyl group, an ethyl group, a propyl group, a butyl group, a pentyl group, a hexyl group, a heptyl group, an octyl group, and a decyl group. The alkyl groups each may be linear or branched. Among these, R^{x2} to R^{x4} each preferably represent an alkyl group having 1 to 4 carbon atoms, more preferably represent a methyl group or an ethyl group, and further preferably represent a methyl group.

In the general formula (x1-1), n1 represents an integer of 0 to 3, and in the case where n1 is 2 or 3, the multiple groups represented by R^{x1} may be the same as or different from each other.

Among the above, the divalent group represented by the general formula (x1-1) is preferably a divalent group represented by the following general formula (x1-1'), i.e., n1 is 0, and R^{x2} to R^{x4} represent methyl groups, more preferably contains one or more kinds selected from the group consisting of a divalent group represented by the following general formula (x1-1") and a divalent represented by the following general formula (x1-1‴), from the standpoint of the manufacturability: 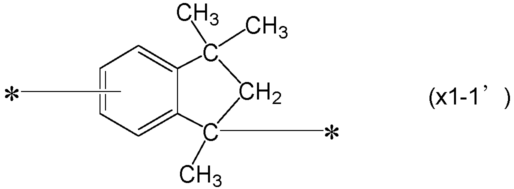 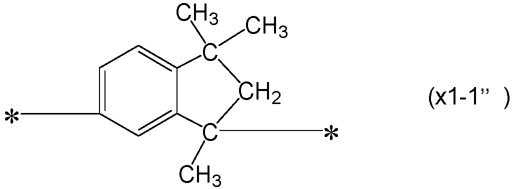 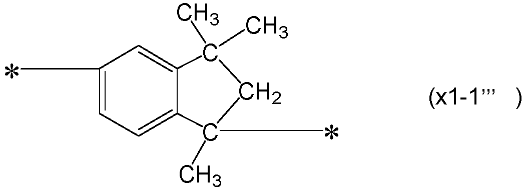 in which * represents a bonding site.

The component (x1) containing the divalent group represented by the general formula (x1-1) is preferably represented by the following general formula (x1-2) from the standpoint of the dielectric characteristics, the low thermal expansion, and the heat resistance, the standpoint of the adhesiveness to a conductor, and the standpoint of the manufacturability: 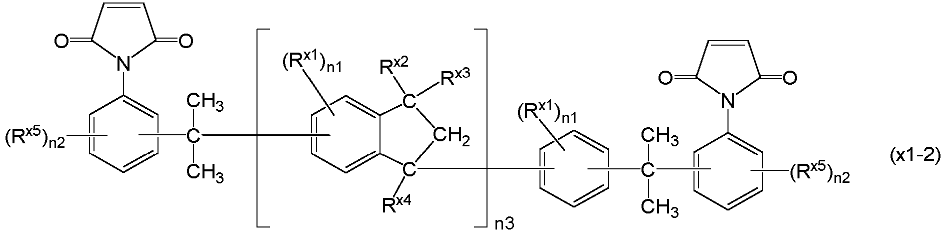 in which R^{x1} to R^{x4} and n1 have the same meanings as in the general formula (x1-1), R^{x5} each independently represent an alkyl group having 1 to 10 carbon atoms, an alkoxy group having 1 to 10 carbon atoms, an alkylthio group having 1 to 10 carbon atoms, an aryl group having 6 to 10 carbon atoms, an aryloxy group having 6 to 10 carbon atoms, an arylthio group having 6 to 10 carbon atoms, a cycloalkyl group having 3 to 10 carbon atoms, a halogen atom, a nitro group, a hydroxy group, or a mercapto group, n2 represents an integer of 0 to 4, and n3 represents a number of 0.95 to 10.0.

In the general formula (x1-2), the multiple groups represented by R^{x1}, the multiple integers represented by n1, the multiple groups represented by R^{x5}, and the multiple integers represented by n2 each may be the same as or different from each other. In the case where n3 exceeds 1, the multiple groups represented by R^{x2}, the multiple groups represented by R^{x3}, the multiple groups represented by R^{x4} each may be the same as or different from each other.

The descriptions for the alkyl group having 1 to 10 carbon atoms, the alkoxy group having 1 to 10 carbon atoms, the alkylthio group having 1 to 10 carbon atoms, the aryl group having 6 to 10 carbon atoms, the aryloxy group having 6 to 10 carbon atoms, the arylthio group having 6 to 10 carbon atoms, and the cycloalkyl group having 3 to 10 carbon atoms represented by R^{x5} in the general formula (x1-2) are the same as the descriptions for the alkyl group having 1 to 10 carbon atoms, the alkoxy group having 1 to 10 carbon atoms, the alkylthio group having 1 to 10 carbon atoms, the aryl group having 6 to 10 carbon atoms, the aryloxy group having 6 to 10 carbon atoms, the arylthio group having 6 to 10 carbon atoms, and the cycloalkyl group having 3 to 10 carbon atoms represented by R^{x1}.

Among these, R^{x5} preferably represents an alkyl group having 1 to 4 carbon atoms, a cycloalkyl group having 3 to 6 carbon atoms, or an aryl group having 6 to 10 carbon atoms, more preferably represents an alkyl group having 1 to 3 carbon atoms, and further preferably represents a methyl group, from the standpoint of the solubility in an organic solvent and the manufacturability.

In the general formula (x1-2), n2 represents an integer of 0 to 4, preferably represents an integer of 1 to 3, and is more preferably 2 or 3, and further preferably 2, from the standpoint of the compatibility with the other resin components, the dielectric characteristics, the adhesiveness to a conductor, and the manufacturability.

In the case where n2 is 1 or more, the benzene ring and the N-substituted maleimide group have a twisted conformation, resulting in a tendency that the solubility in an organic solvent is further enhanced by inhibiting the intermolecular stacking. From the standpoint of inhibiting the intermolecular stacking, in the case where n2 is 1 or more, the substitution position of R^{x5} is preferably the ortho-position with respect to the N-substituted maleimide group.

In the general formula (x1-2), n3 preferably represents the number of 0.98 to 8.0, more preferably the number of 1.0 to 7.0, and further preferably the number of 1.1 to 6.0, from the standpoint of the dielectric characteristics, the adhesiveness to a conductor, the solubility in an organic solvent, the handleability, and the heat resistance.

The component (x1) represented by the general formula (x1-2) is preferably represented by the following general formula (x1-3) from the standpoint of the dielectric characteristics, the adhesiveness to a conductor, the solubility in an organic solvent, and the manufacturability: 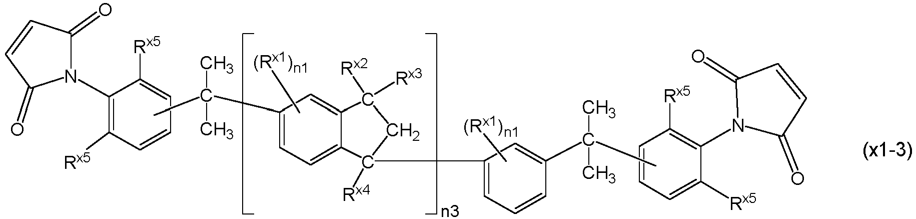 in which R^{x1} to R^{x5}, n1, and n3 have the same meanings as in the general formula (x1-2).

The number average molecular weight of the component (x1) is preferably 200 to 3,000, more preferably 400 to 2,000, and further preferably 500 to 1,000, from the standpoint of the compatibility with the other resins, the adhesiveness to a conductor, and the heat resistance, while not particularly limited.

The component (x1) can be produced, for example, by a method of reacting an intermediate amine compound containing a condensed ring of an aromatic ring and an aliphatic ring (which may be hereinafter referred simply to as an "intermediate amine compound") and maleic anhydride (the reaction of which may be hereinafter referred to as a "maleimidation reaction").

The production method of the component (x1) will be described below with reference to a maleimide compound containing an indane ring as the condensed ring of an aromatic ring and an aliphatic ring, as an example.

The intermediate amine compound of the maleimide compound containing an indane ring can be obtained, for example, by reacting a compound represented by the following general formula (x1-4) (which may be hereinafter referred to as a "compound A") and a compound represented by the following general formula (x1-5) (which may be hereinafter referred to as a "compound B") in the presence of an acid catalyst (the reaction of which may be hereinafter referred to as a "cyclization reaction"), resulting in a compound represented by the following general formula (x1-6): 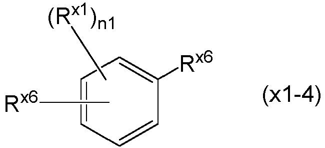 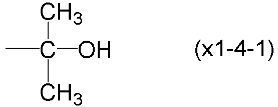 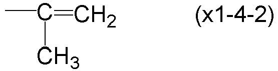 in which R^{x1} and n1 have the same meanings as in the general formula (x1-1), and R^{x6} each independently represent a group represented by the formula (x1-4-1) or the formula (x1-4-2), provided that the o-position of at least one of the groups represented by R^{x6} in the two groups represented by R^{x6} is a hydrogen atom, 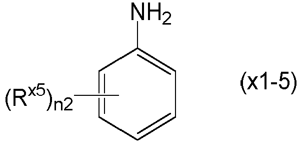 in which R^{x5} and n2 have the same meanings as in the general formula (x1-2), provided that at least one of the o-position and the p-position with respect to the amino group is a hydrogen atom, 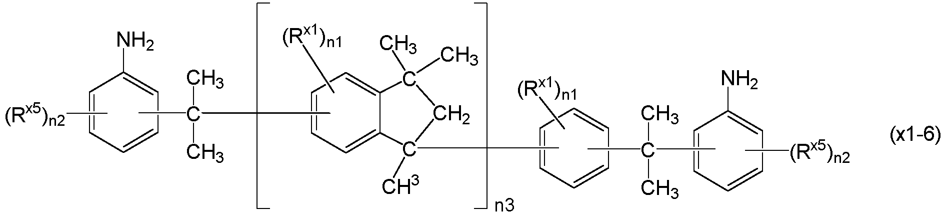 in which R^{x1}, R^{x5}, and n1 to n3 have the same meanings as in the general formula (x1-2).

Examples of the compound A include p- or m-diisopropenylbenzene, p- or m-bis(α-hydroxyisopropyl)benzene, 1-(α-hydroxyisopropyl)-3-isopropenylbenzene, 1-(α-hydroxyisopropyl)-4-isopropenylbenzene, a mixture thereof, nuclear alkyl group substituted compounds thereof, and nuclear halogen substituted compounds thereof.

Examples of the nuclear alkyl group substituted compound include diisopropenyltoluene and bis(α-hydroxyisopropyl)toluene.

Examples of the nuclear halogen substituted compound include chlorodiisopropenylbenzene and chlorobis(α-hydroxyisopropyl)benzene.

One kind of these compounds may be used alone, or two or more kinds thereof may be used in combination.

Examples of the compound B include aniline, dimethylaniline, diethylaniline, diisopropylaniline, ethylmethylaniline, cyclobutylaniline, cyclopentylaniline, cyclohexylaniline, chloroaniline, dichloroaniline, toluidine, xylidine, phenylaniline, nitroaniline, aminophenol, cyclohexylaniline, methoxyaniline, ethoxyaniline, phenoxyaniline, naphthoxyaniline, aminothiol, methylthioaniline, ethylthioaniline, and phenylthioaniline. One kind of these compounds may be used alone, or two or more kinds thereof may be used in combination.

In the cyclization reaction, for example, the first step reaction is performed by charging the compound A and the compound B at a molar ratio thereof (compound B/compound A) of preferably 0.1 to 2.0, more preferably 0.15 to 1.5, and further preferably 0.2 to 1.0.

Subsequently, the second step reaction is preferably performed by adding the additional compound B at a molar ratio with respect to the compound A having been added (additional compound B/compound A) of preferably 0.5 to 20, more preferably 0.6 to 10, and further preferably 0.7 to 5.

Examples of the acid catalyst used in the cyclization reaction include an inorganic acid, such as phosphoric acid, hydrochloric acid, and sulfuric acid; an organic acid, such as oxalic acid, benzenesulfonic acid, toluenesulfonic acid, methanesulfonic acid, and fluoromethanesulfonic acid; a solid acid, such as activated clay, acid clay, silica-alumina, zeolite, and a strong acid ion exchange resin; and heteropolyhydrochloric acid. One kind of these materials may be used alone, or two or more kinds thereof may be used in combination.

The amount of the acid catalyst blended is preferably 5 to 40 parts by mass, more preferably 5 to 35 parts by mass, and further preferably 5 to 30 parts by mass, per 100 parts by mass in total of the compound A and the compound B initially charged, from the standpoint of the reaction rate and the reaction homogeneity.

The reaction temperature of the cyclization reaction is preferably 100 to 300°C, more preferably 130 to 250°C, and further preferably 150 to 230°C, from the standpoint of the reaction rate and the reaction homogeneity.

The reaction time of the cyclization reaction is preferably 2 to 24 hours, more preferably 4 to 16 hours, and further preferably 8 to 12 hours, from the standpoint of the productivity and the sufficient progression of the reaction.

However, these reaction conditions may be appropriately regulated depending on the kinds of the raw materials used and the like, and are not particularly limited.

In the cyclization reaction, an organic solvent, such as toluene, xylene, and chlorobenzene, may be used depending on necessity. In the case where water is by-produced in the cyclization reaction, an organic solvent capable of performing azeotropic dehydration may be used for accelerating the dehydration reaction.

Subsequently, the maleimidation reaction of converting the amino group of the intermediate amine compound to a maleimide group is performed by reacting the intermediate amine compound obtained above and maleic anhydride in an organic solvent, by which the component (x1) can be obtained.

The equivalent ratio of maleic anhydride with respect to the primary amino group equivalent of the intermediate amine compound (maleic anhydride/primary amino group) in the maleimidation reaction is preferably 1.0 to 1.5, more preferably 1.05 to 1.3, and further preferably 1.1 to 1.2, from the standpoint of reducing the unreacted primary amino group and maleic anhydride, while not particularly limited.

Examples of the organic solvent used in the maleimidation reaction an aromatic hydrocarbon, such as toluene, xylene, and mesitylene; a pyrene glycol monomethyl ether compound, such as 1-methoxy-2-propanol propylene glycol monomethyl ether; and a nitrogen-containing aromatic hydrocarbon, such as N-methyl-2-pyrrolidone, while not particularly limited.

The amount of the organic solvent used in the maleimidation reaction is preferably 50 to 5,000 parts by mass, more preferably 70 to 2,000 parts by mass, and further preferably 100 to 500 parts by mass, per 100 parts by mass in total of the intermediate amine compound and maleic anhydride, from the standpoint of the reaction rate and the reaction homogeneity, while not particularly limited.

The maleimidation reaction is preferably performed by reacting the intermediate amine compound and maleic anhydride in two steps.

The reaction temperature in the first step reaction is preferably 10 to 100°C, more preferably 20 to 70°C, and further preferably 30 to 50°C.

The reaction time in the first step reaction is preferably 0.5 to 12 hours, more preferably 0.7 to 8 hours, and further preferably 1 to 4 hours.

The second step reaction is preferably performed after completing the first step reaction, after adding a catalyst, such as toluenesulfonic acid.

The reaction temperature in the second step reaction is preferably 90 to 130°C, more preferably 100 to 125°C, and further preferably 105 to 120°C.

The reaction time in the second step reaction is preferably 2 to 24 hours, more preferably 4 to 10 hours, and further preferably 6 to 10 hours.

However, these reaction conditions may be appropriately regulated depending on the kinds of the raw materials used and the like, and are not particularly limited.

After completing the reaction, the unreacted raw materials, other impurities, and the like can be removed by rinsing with water depending on necessity.

### (Aminomaleimide Compound (X1))

The aminomaleimide compound (X1) is an aminomaleimide compound having a structural unit derived from the maleimide compound (x1) and a structural unit derived from the diamine compound (x2). The aminomaleimide (X1) corresponds to a derivative of the maleimide compound (x1).

One kind of the aminomaleimide (X1) may be used alone, or two or more kinds thereof may be used in combination.

### [Structural Unit derived from Maleimide Compound (x1)]

Examples of the structural unit derived from the component (x1) include a structural unit containing at least one N-substituted maleimide group in the N-substituted maleimide groups of the component (x1) that undergoes the Michael addition reaction with an amino group of the diamine compound (x2).

The aminomaleimide (X1) may contain one kind of the structural unit derived from the component (x1) alone, or may contain two or more kinds thereof.

The content of the structural unit derived from the component (x1) in the aminomaleimide (X1) is preferably 5 to 95% by mass, more preferably 30 to 93% by mass, and further preferably 60 to 90% by mass, while not particularly limited. The content of the structural unit derived from the component (x1) in the aminomaleimide (X1) that is in the range leads to a tendency that the dielectric characteristics and the film handleability are further improved.

### [Structural Unit derived from Diamine Compound (x2)]

Examples of the structural unit derived from the component (x2) include a structural unit containing one or both amino groups of the two amino groups of the component (x2) that undergoes the Michael addition reaction with an N-substituted maleimide group of the maleimide compound (x1).

The aminomaleimide (X1) may contain one kind of the structural unit derived from the component (x2) alone, or may contain two or more kinds thereof.

The amino group of the component (x2) is preferably a primary amino group.

Examples of the structural unit derived from the diamine compound having two primary amino groups include a group represented by the following general formula (x2-1) and a group represented by the following general formula (x2-2): 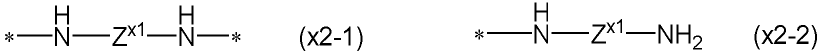 in which Z^{x1} represents a divalent organic group, and * represents a bonding site to another structure.

In the general formulae (x2-1) and (x2-2), Z^{x1} represents a divalent organic group, which corresponds to a divalent group obtained by removing the two amino groups from the component (x2).

In the general formula (x2-1) and the general formula (x2-2), Z^{x1} preferably represents a divalent group represented by the following general formula (x2-3): 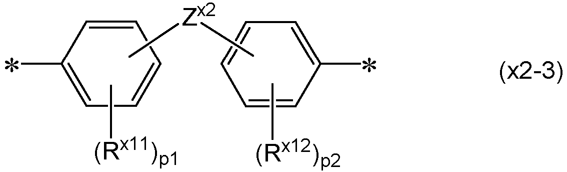 in which R^{x11} and R^{x12} each independently represent an aliphatic hydrocarbon group having 1 to 5 carbon atoms, an alkoxy group having 1 to 5 carbon atoms, a hydroxy group, or a halogen atom, Z^{x2} represents an alkylene group having 1 to 5 carbon atoms, an alkylidene group having 2 to 5 carbon atoms, an ether group, a sulfide group, a sulfonyl group, a carbonyloxy group, a keto group, a fluorenylene group, a single bond, or a divalent group represented by the following general formula (x2-3-1) or (x2-3-2), p1 and p2 each independently represent an integer of 0 to 4, and * represents a bonding site, 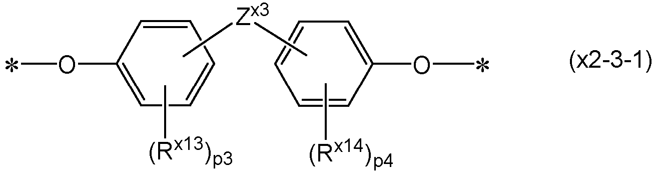 in which R^{x13} and R^{x14} each independently represent an aliphatic hydrocarbon group having 1 to 5 carbon atoms or a halogen atom; Z^{x3} represents an alkylene group having 1 to 5 carbon atoms, an alkylidene group having 2 to 5 carbon atoms, a m-phenylenediisopropylidene group, a p-phenylenediisopropylidene group, an ether group, a sulfide group, a sulfonyl group, a carbonyloxy group, a keto group, or a single bond, p3 and p4 each independently represent an integer of 0 to 4, and * represents a bonding site, 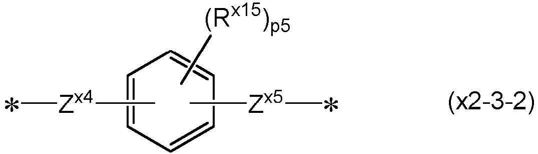 in which R^{x15} represents an aliphatic hydrocarbon group having 1 to 5 carbon atoms or a halogen atom, Z^{x4} and Z^{x5} each independently represent an alkylene group having 1 to 5 carbon atoms, an alkylidene group having 2 to 5 carbon atoms, an ether group, a sulfide group, a sulfonyl group, a carbonyloxy group, a keto group, or a single bond, p5 represents an integer of 0 to 4, and * represents a bonding site.

Examples of the aliphatic hydrocarbon group having 1 to 5 carbon atoms represented by R^{x11}, R^{x12}, R^{x13}, R^{x14}, and R^{x15} in the general formula (x2-3), the general formula (x2-3-1), and the general formula (x2-3-2) include a methyl group, an ethyl group, a n-propyl group, an isopropyl group, a n-butyl group, a t-butyl group, and a n-pentyl group. The aliphatic hydrocarbon group is preferably an aliphatic hydrocarbon group having 1 to 3 carbon atoms, more preferably an alkyl group having 1 to 3 carbon atoms, and further preferably a methyl group or an ethyl group.

Examples of the halogen atom include a fluorine atom, a chlorine atom, a bromine atom, and an iodine atom.

Examples of the alkylene group having 1 to 5 carbon atoms represented by Z^{x2} in the general formula (x2-3), Z^{x3} in the general formula (x2-3-1), and Z^{x4} and Z^{x5} in the general formula (x2-3-2) include a methylene group, a 1,2-dimethylene group, a 1,3-trimethylene group, a 1,4-tetramethylene group, and a 1,5-pentamethylene group. The alkylene group is preferably an alkylene group having 1 to 3 carbon atoms, more preferably an alkylene group having 1 or 2 carbon atoms, and further preferably a methylene group.

Examples of the alkylidene group having 2 to 5 carbon atoms represented by Z^{x2} in the general formula (x2-3), Z^{x3} in the general formula (x2-3-1), and Z^{x4} and Z^{x5} in the general formula (x2-3-2) include an ethylidene group, a propylidene group, an isopropylidene group, a butylidene group, an isobutylidene group, a pentylidene group, and an isopentylidene group. Among these, an alkylidene group having 2 to 4 carbon atoms is preferred, an alkylidene group having 2 or 3 carbon atoms is more preferred, and an isopropylidene group is further preferred.

In the general formula (x2-3), p1 and p2 each independently represent an integer of 0 to 4, and each preferably represent an integer of 0 to 3, more preferably an integer of 0 to 2, and further preferably 0 or 2, from the standpoint of the availability.

In the case where p1 or p2 represents an integer of 2 or more, the multiple groups represented by R^{x11} or R^{x12} may be the same as or different from each other.

In the general formula (x2-3-1), p3 and p4 each independently represent an integer of 0 to 4, and each preferably represent an integer of 0 to 2, more preferably 0 or 1, and further preferably 0, from the standpoint of the availability. In the case where p3 or p4 represents an integer of 2 or more, the multiple groups represented by R^{x13} or R^{x14} may be the same as or different from each other.

In the general formula (x2-3-2), p5 represents an integer of 0 to 4, and preferably represents an integer of 0 to 2, more preferably 0 or 1, and further preferably 0, from the standpoint of the availability. In the case where p5 represents an integer of 2 or more, the multiple groups represented by R^{x15} may be the same as or different from each other.

The content of the structural unit derived from the component (x2) in the aminomaleimide compound (X1) is preferably 5 to 95% by mass, more preferably 7 to 70% by mass, and further preferably 10 to 40% by mass, while not particularly limited. The content of the structural unit derived from the component (x2) in the aminomaleimide compound (X1) that is in the range leads to a tendency that the dielectric characteristics, the heat resistance, the flame retardancy, and the glass transition temperature are improved.

Examples of the component (x2) include 4,4'-diaminodiphenylmethane, 4,4'-diamino-3,3'-dimethyldiphenylmethane, 4,4'-diamino-3,3'-diethyldiphenylmethane, 4,4'-diaminodiphenyl ether, 4,4'-diaminodiphenylsulfone, 3,3'-diaminodiphenylsulfone, 4,4'-diaminodiphenyl ketone, 4,4'-diaminobiphenyl, 3,3'-dimethyl-4,4'-diaminobiphenyl, 2,2'-dimethyl-4,4'-diaminobiphenyl, 3,3'-dihydroxybenzidine, 2,2-bis(3-amino-4-hydroxyphenyl)propane, 3,3'-dimethyl-5,5'-diethyl-4,4'-diaminodiphenylmethane, 2,2-bis(4-aminophenyl)propane, 2,2-bis(4-(4-aminophenoxy)phenyl)propane, 1,3-bis(3-aminophenoxy)benzene, 1,3-bis(4-aminophenoxy)benzene, 1,4-bis(4-aminophenoxy)benzene, 4,4'-bis(4-aminophenoxy)biphenyl, 1,3-bis(1-(4-(4-aminophenoxy)phenyl)-1-methylethyl)benzene, 1,4-bis(1-(4-(4-aminophenoxy)phenyl)-1-methylethyl)benzene, 4,4'-(1,3-phenylenebis(1-methylethylidene))bisaniline, 4,4'-(1,4-phenylenebis(1-methylethylidene))bisaniline, 3,3'-(1,3-phenylenebis(1-methylethylidene))bisaniline, bis(4-(4-aminophenoxy)phenyl)sulfone, bis(4-(3-aminophenoxy)phenyl)sulfone, and 9,9-bis(4-aminophenyl)fluorene.

Among these, the component (x2) is preferably 4,4'-diaminodiphenylmethane, 4,4'-diamino-3,3'-dimethyldiphenylmethane, 4,4'-diamino-3,3'-diethyldiphenylmethane, 2,2-bis(4-(4-aminophenoxy)phenyl)propane, 4,4'-(1,3-phenylenebis(1-methylethylidene))bisaniline, and 4,4'-(1,4-phenylenebis(1-methylethylidene))bisaniline from the standpoint of being excellent in the solubility in an organic solvent, the reactivity with the maleimide compound (x1), and the heat resistance. The component (x2) is preferably 3,3'-dimethyl-5,5'-diethyl-4,4'-diaminodiphenylmethane from the standpoint of being excellent in the dielectric characteristics and the low water absorption. The component (x2) is preferably 2,2-bis(4-(4-aminophenoxy)phenyl)propane from the standpoint of being excellent in the adhesiveness to a conductor and the mechanical characteristics, such as the elongation and the breaking strength. The component (x2) is preferably 4,4'-(1,3-phenylenebis(1-methylethylidene))bisaniline and 4,4'-(1,4-phenylenebis(1-methylethylidene))bisaniline from the standpoint of being excellent in the solubility in an organic solvent, the reactivity in synthesis, the heat resistance, and the adhesiveness to a conductor, and also being excellent in the dielectric characteristics and the low hygroscopicity.

The equivalent ratio (Ta2/Ta1) of the total equivalent amount (Ta2) of the group derived from the -NH₂ group (including the -NH₂ group) in the diamine compound (x2) and the total equivalent amount (Ta1) of the group derived from the N-substituted maleimide group (including the N-substituted maleimide group) of the maleimide compound (x1) in the aminomaleimide compound (X1) is preferably 0.05 to 10, more preferably 0.5 to 7, and further preferably 1 to 5, from the standpoint of the dielectric characteristics, the heat resistance, and the flame retardancy, while not particularly limited.

### (Production Method of Aminomaleimide Compound (X1))

The aminomaleimide compound (X1) can be produced, for example, reacting the maleimide (x1) and the diamine compound (x2) in an organic solvent.

The maleimide (x1) and the diamine compound (x2) are reacted, and thereby the aminomaleimide compound (X1) can be obtained through the Michael addition reaction of the maleimide (x1) and the diamine compound (x2).

In the reaction of the maleimide (x1) and the diamine compound (x2), a reaction catalyst may be used depending on necessity.

Examples of the reaction catalyst include an acidic catalyst, such as p-toluenesulfonic acid; an amine, such as triethylamine, pyridine, and tributylamine; an imidazole compound, such as methylimidazole and phenylimidazole; and a phosphorus based catalyst, such as triphenylphosphine. One kind of these compounds may be used alone, or two or more kinds thereof may be used in combination.

The amount of the reaction catalyst blended is preferably 0.01 to 5 parts by mass, more preferably 0.05 to 3 parts by mass, and further preferably 0.1 to 2 parts by mass, per 100 parts by mass in total of the maleimide (x1) and the diamine compound (x2), from the standpoint of the reaction rate and the reaction homogeneity, while not particularly limited.

The reaction temperature of the Michael addition reaction is preferably 50 to 160°C, more preferably 60 to 150°C, and further preferably 70 to 140°C, from the standpoint of the workability, such as the reaction rate, the suppression of gelation in the reaction, and the like.

The reaction time of Michael addition reaction is preferably 0.5 to 10 hours, more preferably 1 to 8 hours, and further preferably 2 to 6 hours, from the standpoint of the productivity and the sufficient progression of the reaction.

However, these reaction conditions may be appropriately regulated depending on the kinds of the raw materials used and the like, and are not particularly limited.

In the Michael addition reaction, the solid content concentration and the solution viscosity of the reaction solution can be regulated by adding an organic solvent or by concentrating. The solid content concentration of the reaction solution is preferably 10 to 90% by mass, more preferably 15 to 85% by mass, and further preferably 20 to 80% by mass, while not particularly limited. The solid content concentration of the reaction raw materials that is the lower limit value or more leads to a tendency that a favorable reaction rate is obtained, and the productivity is improved. The solid content concentration of the reaction raw materials that is the upper limit value or less leads to a tendency that a good solubility is obtained, the agitation efficiency is enhanced, and the gelation is further prevented.

### (Inorganic Filler (B))

The resin sheet of the present embodiment contains an inorganic filler as a component (B), and the content of the component (B) is 40 to 95% by volume based on the total amount of the resin sheet. The component (B) that is contained in the prescribed amount can enhance the low thermal expansion, and simultaneously reduces the tackiness of the resin sheet, facilitating peeling the resin sheet from a support medium. One kind of the component (B) may be used alone, or two or more kinds thereof may be used in combination.

Examples of the inorganic filler include silica, alumina, titanium oxide, mica, beryllia, barium titanate, potassium titanate, strontium titanate, calcium titanate, aluminum carbonate, magnesium hydroxide, aluminum hydroxide, aluminum silicate, calcium carbonate, calcium silicate, magnesium silicate, silicon nitride, boron nitride, clay, such as baked clay, talc, aluminum borate, and silicon carbide, while not particularly limited. One kind of these materials may be used alone, or two or more kinds thereof may be used in combination. Among these, silica, alumina, mica, and talc are preferred, silica and alumina are more preferred, and silica is further preferred, from the standpoint of the thermal expansion coefficient, the elastic modulus, the heat resistance, and the flame retardancy. Examples thereof include precipitated silica having a high water content produced by the wet method, and dry process silica having substantially no bound water produced by the dry method, and examples of the dry process silica include crushed silica, fumed silica, and molten silica (molten spherical silica), which are classified by the production process.

The shape of the inorganic filler is not particularly limited, and may be any shape of a spherical shape, an acicular shape, a scale-like shape, a planar shape, and the like, and a spherical shape is preferred from the standpoint of enhancing the packing density.

In the present embodiment, however, the inorganic filler (B) does not include a fiber substrate, such as a glass cloth, and also does not include glass fibers. In the case where the resin sheet of the present embodiment contains a fiber substrate, such as a glass cloth, or glass fibers, these materials are contained as an additional component but not the component (B), and the content thereof is preferably in the range described above (i.e., 10% by volume or less, preferably 7% by volume or less, more preferably 5% by volume or less, and further preferably 3% by volume or less, based on the total amount of the resin sheet).

The inorganic filler may not be surface-treated with a coupling agent, but may be surface-treated with a coupling agent, such as a silane coupling agent, and is preferably surface-treated with a coupling agent, such as a silane coupling agent, from the standpoint of enhancing the dispersibility thereof in the resin sheet.

Examples of the silane coupling agent include an aminosilane based coupling agent, an epoxysilane based coupling agent, a phenylsilane based coupling agent, an alkylsilane based coupling agent, an alkenylsilane based coupling agent, an alkynylsilane based coupling agent, a haloalkylsilane based coupling agent, a siloxane based coupling agent, a hydrosilane based coupling agent, a silazane based coupling agent, an alkoxy silane based coupling agent, a chlorosilane based coupling agent, a (meth)acrylic silane based coupling agent, an isocyanurate silane based coupling agent, an ureidosilane based coupling agent, a mercaptosilane based coupling agent, a sulfidosilane based coupling agent, and an isocyanatosilane based coupling agent. Among these, an aminosilane based coupling agent is preferred.

The average particle diameter of the inorganic filler is preferably 0.01 to 20 µm, more preferably 0.1 to 10 µm, further preferably 0.2 to 5 µm, and particularly preferably 0.3 to 3 µm, and may be 0.3 to 1.5 µm, while not particularly limited.

The inorganic filler may be a combination of multiple kinds thereof having different average particle diameters. The combination use of multiple kinds thereof having different average particle diameters leads to a tendency that the inorganic filler can be highly packed the resin sheet. Examples thereof include an embodiment using an inorganic filler a having an average particle diameter of 0.1 to 0.8 µm, an inorganic filler b having an average particle diameter of more than 0.08 to 1.5 µm, and an inorganic filler c having an average particle diameter of more than 1.5 to 3.5 µm, in combination, while not particularly limited. In this case, the mixing ratio thereof in terms of mass ratio (inorganic filler a)/((inorganic filler b)+(inorganic filler c)) is preferably 5/5 to 9/1, and more preferably 6/4 to 8/2. Assuming the above mixing ratio, the mixing ratio of the inorganic filler b and the inorganic filler c in terms of mass ratio (inorganic filler b)/(inorganic filler c) is preferably 5/5 to 8/2, and more preferably 6/4 to 8/2.

In the description herein, the average particle diameter is a particle diameter corresponding to a volume of 50% in a cumulative frequency distribution curve of the particle diameter assuming that the total volume of the particles is 100%. The particle diameter of the inorganic filler can be measured with a particle size distribution measuring device using the laser diffractometry or the like, which is similarly applied to the following description.

The content of the component (B) is 40 to 95% by volume based on the total amount of the resin sheet as described above, and is preferably 50 to 95% by volume, more preferably 60 to 95% by volume, further preferably 65 to 92% by volume, and particularly preferably 70 to 90% by volume. In the case where the content of the component (B) is the lower limit value or less, the excellent low thermal expansion can be obtained, and the tackiness of the resin sheet can be sufficiently reduced.

As described above, in the present embodiment, the component (B) can be highly packed in the resin sheet due to the feature A achieved thereby. In the case of a prepreg but not the resin sheet of the present embodiment, the feature A cannot be achieved, and thus the substantial upper limit of the content of the inorganic filler is 55% by volume based on the total amount of the resin composition in the prepreg. In the case where the inorganic filler is packed in the prepreg to a content exceeding 55% by volume, the inorganic filler overflows due to the presence of the fiber substrate, making it difficult to melt the resin composition, and as a result, the prepreg cannot be produced (see Comparative Examples 3 and 4).

### (Organic Filler (C))

The resin sheet of the present embodiment may further contain an organic filler as a component (C). The organic filler contained in the resin sheet of the present embodiment leads a tendency that the dielectric loss tangent (Df) is further decreased, and a tendency that the dielectric constant (Dk) can be easily regulated to the prescribed range described above.

Examples of the organic filler include resin particles having a unitary structure of a resin, such as polyethylene, polypropylene, polystyrene, a polyphenylene ether resin, a silicone resin, and a tetrafluoroethylene resin; and resin particles having a core-shell structure including a core layer in a rubber state of a resin, such as an acrylate ester based resin, a methacrylate ester based resin, and a conjugated diene based resin, and a shell layer in a glass state of a resin, such as an acrylate ester based resin, a methacrylate ester based resin, an aromatic vinyl based resin, and a vinyl cyanide based resin, while not particularly limited.

The average particle diameter of the organic filler is preferably 0.1 to 10 µm, more preferably 0.2 to 5 µm, further preferably 0.5 to 4.0 µm, and particularly preferably 1.5 to 4.0 µm.

In the case where the resin sheet of the present embodiment contains the organic filler (C), the content thereof is preferably 1 to 30% by volume, more preferably 3 to 25% by volume, and further preferably 5 to 20% by volume, based on the total amount of the resin sheet, while not particularly limited.

### (Thermal Polymerization Initiator (D))

The resin sheet of the present embodiment may further contain a thermal polymerization initiator as a component (D).

Examples of the thermal polymerization initiator include an organic peroxide, for example, a hydroperoxide based compound, such as diisopropylbenzene hydroperoxide "Percumyl P" (trade name, available from NOF Corporation (hereinafter the same)), cumene hydroperoxide "Percumyl H", and t-butyl hydroperoxide "Perbutyl H"; a dialkyl peroxide based compound, such as α,α-bis(t-butylperoxy-m-isopropyl)benzene "Perbutyl P", dicumyl peroxide "Percumyl D", 2,5-dimethyl-2,5-bis(t-butylperoxy)hexane "Perhexa 25B", t-butylcumyl peroxide "Perbutyl C", di-t-butyl peroxide "Perbutyl D", 2,5-dimethyl-2,5-bis(t-butylperoxy)hexyne-3 "Perhexyne 25B", and t-butylperoxy-2-ethyl hexanoate "Perbutyl O"; a ketone peroxide based compound; a peroxyketal based compound, such as n-butyl 4,4-di(t-butylperoxy)valerate "Perhexa V"; a peroxy dicarbonate based compound; and a peroxy ester based compound; and an azo compound, such as 2,2'-azobisisobutyronitrile, 2,2'-azobis(2-cyclopropylpropionitrile), and 2,2'-azobis(2,4-dimethylvaleronitrile), while not particularly limited. Among these, α,α-bis(t-butylperoxy-m-isopropyl)benzene "Perbutyl P" is preferred.

In the case where the resin sheet of the present embodiment contains the thermal polymerization initiator (D), the content thereof is preferably 0.01 to 5% by mass, more preferably 0.1 to 4% by mass, and further preferably 0.5 to 3% by mass, based on the component (A), while not particularly limited. The content of the thermal polymerization initiator (D) that is the lower limit value or more leads to a tendency that a sufficiently thermally cured resin sheet can be easily obtained, and the content thereof that is the upper limit value or less leads to a tendency that the heat resistance is improved.

### (Additional Component)

The resin sheet of the present embodiment may further contain an additional component. Examples of the additional component include a curing accelerator, a flame retardant, a flame retardant promoter, a peroxide, an antioxidant, a fluorescent whitener, an adhesiveness improver, a thermal stabilizer, an antistatic agent, an ultraviolet ray absorbent, a pigment, a colorant, and a lubricant, while not particularly limited.

In the case where the resin sheet of the present embodiment contains the additional component, the content thereof is preferably 5% by mass or less, more preferably 3% by mass or less, and further preferably 1% by mass or less, per one kind thereof, based on the total amount of the resin sheet.

### (Thickness of Resin Sheet)

The thickness of the resin sheet of the present embodiment is preferably a thickness that is equivalent to one ply of a prepreg having been applied to the purpose of a printed wiring board, and is preferably 40 to 120 µm, more preferably 50 to 110 µm, further preferably 60 to 100 µm, and particularly preferably 70 to 100 µm. The thickness of the resin sheet of the present embodiment is not limited to the aforementioned range.

### (Production Method of Resin Sheet)

The resin sheet of the present embodiment can be produced, for example, in such a manner that a resin composition containing the components described above and, depending on necessity, an organic solvent is coated on a support medium, and dried to the B-stage, and then the support medium is peeled off. In the description herein, the B-stage means the B-stage that is defined in JIS K6900:1994, and may also be referred to as semicuring.

Examples of the support medium include a film of a polyolefin, such as polyethylene, polypropylene, and polyvinyl chloride; a film of a polyester, such as polyethylene terephthalate (which may be hereinafter referred to as "PET") and polyethylene naphthalate; various plastic films, such as a polycarbonate film and a polyimide film; a metal foil, such as a copper foil and an aluminum foil; and release paper. The support medium may be subjected to a surface treatment, such as a matting treatment and a corona treatment. The support medium may be subjected to a release treatment with a silicone resin based release agent, an alkyd resin based release agent, a fluorine resin based release agent, or the like.

The thickness of the support medium is preferably 10 to 150 µm, and more preferably 25 to 50 µm, while not particularly limited.

The method of coating the resin composition on the support medium is not particularly limited, and the resin composition may be coated with a coating device having been known in the art, such as a comma coater, a bar coater, a kiss coater, a roll coater, a gravure coater, and a die coater. The coating device can be appropriately selected corresponding to the thickness of the resin sheet to be produced.

The drying temperature and the drying time of the resin composition after coating are not particularly limited, and examples thereof include a method of drying at 50 to 140°C for approximately 3 to 15 minutes. The drying temperature is preferably 70 to 135°C, and more preferably 80 to 130°C. The drying time is preferably 5 to 12 minutes.

The resin sheet of the present embodiment may have a protective film provided on one surface or both surfaces thereof. The protective film provided can prevent damages during transportation. The resin sheet of the present embodiment may not have a protective film provided thereon.

### [Laminated Board and Metal-clad Laminated Board]

The laminated board of the present embodiment is a laminated board including a cured product of the resin sheet of the present embodiment. A laminated board including a metal foil may also be referred to as a metal-clad laminated board, and therefore, the metal-clad laminated board of the present embodiment is a metal-clad laminated board including a metal foil and a cured product of the resin sheet of the present embodiment.

The metal-clad laminated board of the present embodiment can be produced, for example, in such a manner that a metal foil is disposed on one surface or both surfaces of one ply of the resin sheet of the present embodiment, or a metal foil is disposed on one surface or both surfaces of a laminated sheet obtained by laminating two or more plies (preferably 2 to 10 plies) of the resin sheets of the present embodiment, and then the assembly is molded under heat and pressure.

Examples of another embodiment of the production method of the metal-clad laminated board of the present embodiment include such a method that a metal foil is disposed on one surface or both surfaces of one ply of the resin sheet of the present embodiment, with one or more plies of a resin film other than the present embodiment intervening therebetween, and then the assembly is molded under heat and pressure. In the case where two or more plies of the resin films other than the present embodiment used in this method, the same resin films may be used, or different resin films may be used in combination. The resin film used herein may be a known resin film with a support medium having been used for forming a multilayer structure of a printed wiring board.

Examples of still another embodiment of the production method of the metal-clad laminated board of the present embodiment include such a method that a metal foil is disposed on one surface or both surfaces of a laminated sheet obtained by laminating two or more plies (preferably 2 to 10 plies) of the resin sheets of the present embodiment, with one or more plies of a resin film other than the present embodiment intervening therebetween, and then the assembly is molded under heat and pressure. In the case where two or more plies of the resin films other than the present embodiment used in this method, the same resin films may be used, or different resin films may be used in combination.

The metal of the metal foil is not particularly limited, as far as being used for the purpose of an electric insulating material, and copper, gold, silver, nickel, platinum, molybdenum, ruthenium, aluminum, tungsten, iron, titanium, chromium, and an alloy containing one or more kinds of these metals may be used, in which copper and aluminum are preferred, and copper is more preferred, from the standpoint of the conductivity.

As for the condition in molding under heat and pressure, for example, the temperature is preferably 100 to 300°C, more preferably 150 to 250°C, and further preferably 180 to 230°C, the pressure is preferably 0.2 to 10 MPa, and more preferably 2 to 6 MPa, and the time is preferably 0.1 to 5 hours, and more preferably 1 to 3 hours, while not particularly limited. The method of molding under heat and pressure may be performed by a method of retaining a vacuum state with a vacuum press or the like preferably for 0.5 to 5 hours.

In the laminated board and the metal-clad laminated board of the present embodiment, the resin sheet is in the C-stage, i.e., becomes a cured product. Therefore, it can also be said that the laminated board of the present embodiment includes the resin sheet in the C-stage, and the metal-clad laminated board of the present embodiment includes the resin sheet in the C-stage and a metal foil.

In the description herein, the C-stage means the C-stage that is defined in JIS K6900:1994.

### [Printed Wiring Board]

The printed wiring board of the present embodiment includes the laminated board or the metal-clad laminated board of the present embodiment. The expression "including the laminated board or the metal-clad laminated board" herein encompasses the case where the laminated board or the metal-clad laminated board is included as it is, and the case where the laminated board or the metal-clad laminated board is included after subjecting the board to a circuit forming process, such as perforating, metal plating, and etching the metal foil, and the like.

The printed wiring board of the present embodiment can be produced in such a manner that the laminated board of the present embodiment having a metal foil provided on one surface or both surfaces thereof, i.e., the metal-clad laminated board, is subjected to a circuit forming process, such as perforating, metal plating, and etching the metal foil, by a known method, and further subjected to a multilayer structure forming process depending on necessity.

### [Semiconductor Package]

The semiconductor package of the present embodiment is a semiconductor package including the printed wiring board of the present embodiment and a semiconductor device. The semiconductor package of the present embodiment can be produced in such a manner that semiconductor devices, such as a semiconductor chip and a memory device, are mounted at prescribed positions on the printed wiring board of the present embodiment, and the semiconductor devices are sealed with a sealing resin or the like.

The resin sheet, the laminated board, the printed wiring board, and the semiconductor package of the present embodiment can be favorably applied to an electronic equipment processing a high frequency signal of 10 GHz or more. In particular, the printed wiring board is useful as a printed wiring board for millimeter-wave radar.

The preferred embodiments having been described above are only examples for describing the present disclosure, and do not have an intent of limiting the scope of the present disclosure to the embodiments. The present disclosure encompasses implementations of various embodiments different from the embodiments described above, unless deviating from the spirit thereof.

### Examples

The present embodiment will be specifically described with reference to examples below. However, the present embodiment is not limited to the examples.

### Examples 1 to 13 and Comparative Example 1 to 4

### (Production of Resin Sheet)

The components shown in Table 1 or Table 2 were mixed and agitated with toluene according to the blending amounts shown in Table 1 or Table 2 at room temperature (25°C), so as to prepare a resin composition having a solid content concentration of 68% by mass.

The resin composition thus prepared was coated on a PET film having a thickness of 38 µm (available from Toyobo Co., Ltd, trade name, Peulex (registered trademark) A5300), and then dried under heating at 130°C for 10 minutes to convert the resin composition into the B-stage, resulting in a resin sheet with a PET film. For the resin sheet with a PET film, the corner of the PET film was held with tweezers, and the PET film was slowly peeled off from the resin sheet toward the opposite corner on the diagonal line, so as to provide the bare resin sheet.

### (Production of Copper-clad Laminated Board)

Four plies of the resin sheets obtained by the aforementioned method were laminated to form a laminated sheet. Low profile copper foils having a thickness of 18 µm (available from Mitsui Mining & Smelting Co., Ltd., trade name, SI VSP AM 3R) were disposed on the upper and lower sides of the laminated sheet in such a manner that the M surface (matte surface) thereof was brought into contact with the laminated sheet, and the assembly was molded under heat and pressure at a temperature of 200°C and a pressure of 4 MPa for 120 minutes to convert the resin sheet to the C-stage, resulting in a double-sided copper-clad laminated board.

### [Evaluation and Measurement Methods]

The resin sheets and the copper-clad laminated boards obtained in Examples and Comparative Examples were measured and evaluated according to the following methods. The results are shown in Table 1 or Table 2.

### (1. Evaluation of Flexibility)

The resin sheet with a PET film was wound on a cylinder having a diameter of 45 mm, and then the resin sheet was released. The resin sheet thus released was visually observed, and evaluated according to the following evaluation standard.
A: No crack existed.
C: Cracks existed.

### (2. Self-standing Capability)

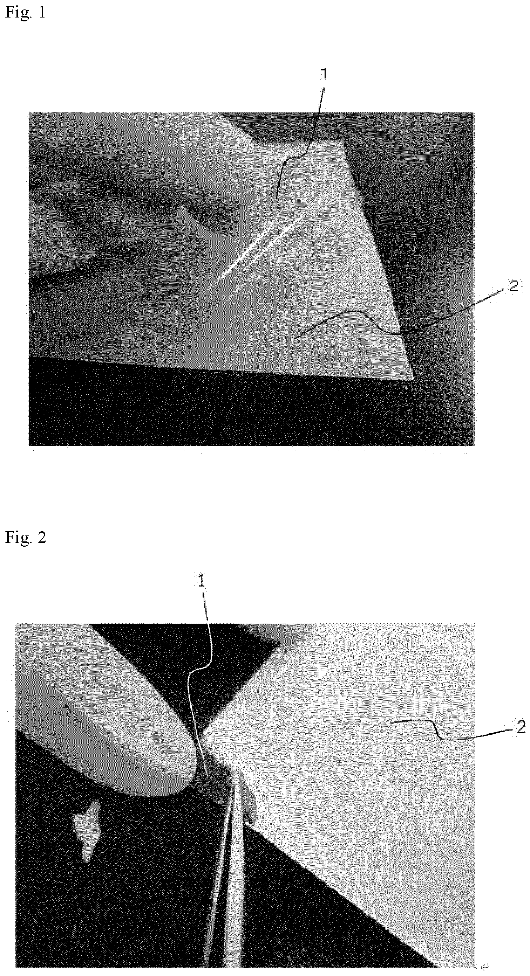

For the resin sheet with a PET film, the corner of the PET film was held with tweezers, as described above, and then after holding the corner with the hand, the PET film was slowly peeled off from the resin sheet toward the opposite corner on the diagonal line. The state at this time was evaluated according to the following evaluation standard, which was designated as the index of the self-standing capability. The photograph in the evaluation in Example 3 is shown in Fig. 1, and the photograph in the evaluation in Comparative Example 1 is shown in Fig. 2.
A: The PET film was peeled off from the resin sheet without breaking the resin sheet. The corner of the bare resin sheet was held with the fingers and shaken with a width of 10 cm, but the resin sheet was not broken.
C: The resin sheet was shattered in peeling the PET film, and no bare resin sheet was obtained.

### (3. Measurement and Evaluation of Content of Organic Solvent)

The resin sheets obtained in the examples each were cut into a 4 cm square, which was measured for the weight thereof, and then measured for the weight of the resin sheet after heating at 170°C for 1 hour. The weight of the organic solvent evaporated was calculated from the difference between the weight of the resin sheet before heating at 170°C and the weight of the resin sheet after heating, and evaluated according to the following evaluation standard. The weight of the organic solvent evaporated corresponds to the content of the organic solvent contained in the resin sheet before heating at 170°C.
A: The content of the organic solvent evaporated was less than 1% by mass.
C: The content of the organic solvent evaporated exceeded 1% by mass.

### (4. Measurement of Dielectric Constant and Dielectric Loss Tangent)

The double-sided copper-clad laminated boards obtained in the examples each were immersed in a 10% by mass solution of ammonium persulfate (available from Mitsubishi Gas Chemical Company, Inc.) as a copper etching solution, so as to remove the copper foil, resulting in an evaluation board, from which an evaluation board of 2 mm × 50 mm was produced.

The evaluation board was measured for the dielectric constant and the dielectric loss tangent in a 10 GHz band at 25°C with "PNA Network Analyzer N5227A" (available from Agilent Technologies, Inc.) equipped with a split post dielectric resonator (SPDR).

### (5. Measurement Thermal Expansion Rate)

The double-sided copper-clad laminated boards obtained in the examples each were immersed in the copper etching solution to remove the copper foil, resulting in an evaluation board of a 5 mm square, which was subj ected to thermomechanical analysis by the compression method with a thermomechanical analyzer (TMA) (available from TA Instruments Japan, Inc., Q400 (model number)).

The evaluation board was mounted on the analyzer in the X direction, and measured twice consecutively under condition of a load of 5 g and a temperature rise rate of 10°C/min. The average thermal expansion rate (i.e., the average of the linear thermal expansion rates in the plane direction) from 50°C to 120°C in the second measurement was calculated and designated as the value of the thermal expansion rate (linear thermal expansion rate). The result of the second measurement was used for enhancing the accuracy.

### (6. Measurement of Glass Transition Temperature (Tg))

The double-sided copper-clad laminated boards obtained in the examples each were immersed in the copper etching solution to remove the copper foil, resulting in an evaluation board of a 5 mm square, which was measured for the glass transition temperature according to IPC (The Institute for Interconnecting and Packaging Electronic Circuits) standard with a thermomechanical analyzer (TMA) (available from TA Instruments Japan, Inc., Q400 (model number)).

The higher the glass transition temperature is, the better the heat resistance is.

**Table 1**

| | | | | | Example | | | | | | | | |
|---|---|---|---|---|---|---|---|---|---|---|---|---|---|
| | | | | Unit | 1 | 2 | 3 | 4 | 5 | 6 | 7 | 8 | 9 |
| Component (A) | | Elastomer (A1) of Mn 10,000 or more | Elastomer 1 (Mn = 20,000) | part by mass | | | | | | | | | |
| | | | Elastomer 2 (Mn = 150,000) | part by mass | 50 | 50 | 50 | 50 | 50 | 40 | 50 | 60 | 50 |
| | | Elastomer (A2) of Mn less than 10,000 | Elastomer 3 (Mn = 1,200) | part by mass | 30 | 30 | 30 | 30 | 30 | 40 | 40 | 20 | 20 |
| | | | Elastomer 4 (Mn = 3,200) | part by mass | | | | | | | | | |
| | | Thermosetting resin (A3) | Bismaleimide compound | part by mass | 20 | 20 | 20 | 20 | 20 | 20 | 10 | 20 | 30 |
| Component (B) | | Inorganic filler | Silica | % by volume | 40 | 60 | 70 | 80 | 90 | 70 | 70 | 70 | 70 |
| Component (C) | | Thermal polymerization initiator | Thermal polymerization initiator 1 | part by mass | 2 | 2 | 2 | 2 | 2 | 2 | 2 | 2 | 2 |
| Product form | | | | - | resin sheet | | | | | | | | |
| Thickness of resin sheet or prepreg | | | | µm | 100 | | | | | | | | |
| Content of glass cloth based on resin sheet or prepreg | | | | % by volume | 0 | 0 | 0 | 0 | 0 | 0 | 0 | 0 | 0 |
| Evaluation results | Resin sheet | Flexibility | | - | A | A | A | A | A | A | A | A | A |
| | | Self-standing capability | | - | A | A | A | A | A | A | A | A | A |
| | | Content of organic solvent | | - | A | A | A | A | A | A | A | A | A |
| | Laminated board | Dielectric characteristics | Dielectric constant (Dk) in 10 GHz band | - | 2.70 | 2.93 | 3.05 | 3.10 | 3.14 | 3.05 | 3.00 | 3.05 | 3.10 |
| | | | Dielectric loss tangent (Df) in 10 GHz band | - | 0.00095 | 0.00085 | 0.00071 | 0.00050 | 0.00045 | 0.00073 | 0.00060 | 0.00069 | 0.00082 |
| | | Thermal expansion rate | | ppm/°C | 92 | 45 | 30 | 18 | 9 | 33 | 60 | 27 | 15 |
| | | Glass transition temperature | | °C | 160 | 196 | 215 | 220 | 225 | 217 | 200 | 213 | 230 |

**Table 2**

| | | | | | Example | | | | Comparative Example | | | |
|---|---|---|---|---|---|---|---|---|---|---|---|---|
| | | | | Unit | 10 | 11 | 12 | 13 | 1 | 2 | 3 | 4 |
| Component (A) | | Elastomer (A1) of Mn 10,000 or more | Elastomer 1 (Mn = 20,000) | part by mass | 50 | 60 | 100 | | | | | |
| | | | Elastomer 2 (Mn = 150,000) | part by mass | | | | 100 | | | 50 | 50 |
| | | Elastomer (A2) of Mn less than 10,000 | Elastomer 3 (Mn = 1,200) | part by mass | 30 | 20 | | | 100 | | 30 | 30 |
| | | | Elastomer 4 (Mn = 3,200) | part by mass | | | | | | 100 | | |
| | | Thermosetting resin (A3) | Bismaleimide compound | part by mass | 20 | 20 | | | | | 20 | 20 |
| Component (B) | | Inorganic filler | Silica | % by volume | 70 | 70 | 70 | 70 | 70 | 70 | 70 | 80 |
| Component (C) | | Thermal polymerization initiator | Thermal polymerization initiator 1 | part by mass | 2 | 2 | 2 | 2 | 2 | 2 | 2 | 2 |
| Product form | | | | - | resin sheet | | | | resin sheet | | prepreg | |
| Thickness of resin sheet or prepreg | | | | µm | 100 | | | | 100 | | - | - |
| Content of glass cloth based on resin sheet or prepreg | | | | % by volume | 0 | 0 | 0 | 0 | 0 | 0 | 30 | |
| Evaluation results | Resin sheet | Flexibility | | - | A | A | A | A | A | A | unmeasurable | |
| | | Self-standing capability | | - | A | A | A | A | C | C | | |
| | | Content of organic solvent | | - | A | A | A | A | A | A | | |
| | Laminated board | Dielectric characteristics | Dielectric constant (Dk) in 10 GHz band | - | 3.24 | 3.25 | 3.10 | 3.04 | - | - | | |
| | | | Dielectric loss tangent (Df) in 10 GHz band | - | 0.00085 | 0.00088 | 0.00090 | 0.00060 | - | - | | |
| | | Thermal expansion rate | | ppm/°C | 24 | 22 | 134 | 182 | - | - | | |
| | | Glass transition temperature | | °C | 217 | 218 | 211 | 187 | - | - | | |

The components shown in Table 1 or Table 2 are as follows.

### [Component (A)]

### (Component (A1))

Elastomer 1: Long-chain alkyl group-containing bismaleimide compound having the following structure, Mn = 20,000 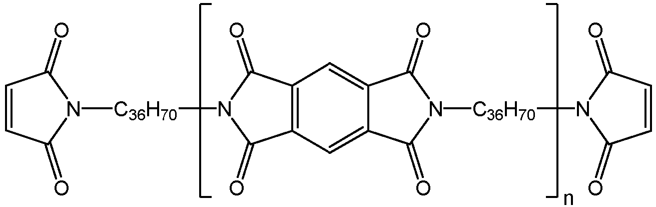 in which n represents an integer of 1 to 10
Elastomer 2: Styrene-ethylene-butylene-styrene copolymer (SEBS), styrene content ratio: 12% by mass, hydrogenation rate: 100% by mol, Mn = 150,000

### (Component (A2))

Elastomer 3: 1,2-Polybutadiene homopolymer, Mn = 1,200
Elastomer 4: 1,2-Polybutadiene homopolymer, Mn = 3,200

### (Component (A3))

Bismaleimide compound: Aromatic bismaleimide compound containing an indane ring having the following structure 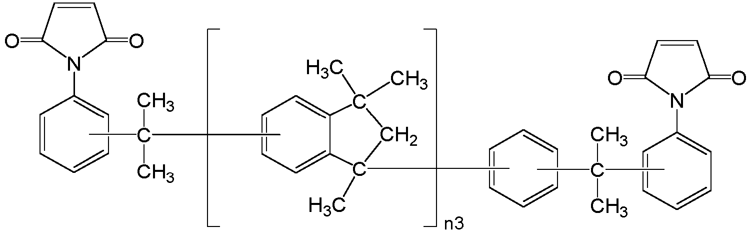 in which n3 represents the number of 0.95 to 10.0

### [Component (B)]

Silica: Silica obtained by mixing silica a having an average particle diameter of 0.6 µm treated with an aminosilane based coupling agent, silica b having an average particle diameter of 1.0 µm treated with an aminosilane based coupling agent, and silica c having an average particle diameter of 2.4 µm treated with an aminosilane based coupling agent at a ratio of a/b/c = 7/2/1 (mass ratio)

### [Component (C)]

Thermal polymerization initiator 1: α,α-bis(t-Butylperoxy-m-isopropyl)benzene

The number average molecular weight of the component (A) was measured according to the following method.

### (Measurement Method of Number Average Molecular Weight (Mn))

The number average molecular weight was measured by gel permeation chromatography (GPC) converting with a calibration curve using the standard polystyrene. The calibration curve was approximated by the cubic equation using the standard polystyrene, TSKstandard Polystyrene (Type A-2500, A-5000, F-1, F-2, F-4, F-10, F-20, F-40, trade names, available from Tosoh Corporation). The measurement condition of GPC is shown below.

### [Measurement Condition of GPC]

Apparatus: High-speed GPC apparatus HLC-8320GPC
Detector: UV absorption detector UV-8320 (available from Tosoh Corporation)
Columns: Guard column: TSK Guardcolumn SuperHZ-L, Columns: TSKgel SuperHZM-N, TSKgel SuperHZM-M, TSKgel SuperH-RC (trade names, all available from Tosoh Corporation)
Column size: 4.6 × 20 mm (guard column), 4.6 × 150 mm (column), 6.0 × 150 mm (reference column)
Eluent: Tetrahydrofuran
Sample concentration: 10 mg/5 mL
Injection amount: 25 µL
Flow rate: 1.00 mL/min
Measurement temperature: 25°C

As apparent from the results shown in Table 1 and Table 2, it is understood that the resin sheets produced in Examples satisfy (1) the handleability without the use of a support medium, (2) the low thermal expansion, (3) a dielectric constant (Dk) in a high frequency band of a 10 GHz band or higher of 2.65 to 3.30, and (4) a dielectric loss tangent (Df) in a high frequency band of a 10 GHz band or higher of 0.00097 or less, and furthermore, the resin sheets produced in Examples have the feature of (5) the excellent flexibility, irrespective of the small content of an organic solvent, and thus are less likely to suffer cracks, resulting in the excellent handleability. The resin sheets produced in Examples also have an advantage that voids are less likely to occur in a reflow process due to the small content of an organic solvent thereof.

On the other hand, Comparative Examples 1 and 2 producing the resin sheets containing no component (A1) have a problem in self-standing capability, and thus cannot be used as a substitute of a prepreg. In Comparative Examples 3 and 4 trying to produce a prepreg by impregnating a glass cloth with a resin composition having a content of silica of 70 to 80% by mass, the resin component is not melted, and the glass cloth cannot be impregnated with the resin component, failing to produce a satisfactory prepreg.

Assuming that a prepreg can be produced in Comparative Examples 3 and 4, the theoretical values of the dielectric constant (Dk) and the dielectric loss tangent (Df) of the prepreg are calculated by the following expressions. As a result, it has been found that the dielectric constant (Dk) is 3.35 for Comparative Example 3 and 3.39 for Comparative Example 4, both of which exceed the prescribed range described above, and the dielectric loss tangent (Df) becomes as high as 0.00125 for Comparative Example 3 and 0.00110 for Comparative Example 4. It is estimated that the results are derived from the fact that the prepreg contains a glass cloth, from which it is understood that a prepreg containing glass fibers, such as a glass cloth, is difficult to solve the problems. (Dielectric constant (Dk) of glass cloth) = (Dk of glass cloth) × (content of glass cloth (volume based)) + (Dk of resin composition) × (content of resin composition (volume based)) (Dielectric loss tangent ((Dk) of glass cloth) = (Dk of glass cloth) × (content of glass cloth (volume based)) + (Dk of resin composition) × (content of resin composition (volume based))

In the expressions 1 and 2, the contents are volume based fractions based on the prepreg.

### Reference Sign List

1: PET film
2: Resin sheet

## Claims

1. A resin sheet comprising a resin component (A) and an inorganic filler (B),
the component (A) containing an elastomer (A1) having a number average molecular weight of 10,000 or more, having a content of the component (A1) of 30% by mass or more based on the component (A),
the resin sheet having a content of the component (B) of 40 to 95% by volume based on the total amount of the resin sheet.

2. The resin sheet according to claim 1, wherein the resin sheet has a content of the component (B) of 60 to 95% by volume based on the total amount of the resin sheet.

3. The resin sheet according to claim 1 or 2, wherein the resin sheet further comprises an elastomer (A2) having a number average molecular weight of less than 10,000.

4. The resin sheet according to any one of claims 1 to 3, wherein the component (A) further contains a thermosetting resin (A3).

5. The resin sheet according to claim 4, wherein the component (A) has a total content of the component (A1) and the component (A2) of 60 to 95% by mass based on the component (A).

6. The resin sheet according to any one of claims 1 to 5, wherein the resin sheet comprises no organic solvent, or comprises an organic solvent in a content thereof of less than 1% by mass based on the total amount of the resin sheet.

7. The resin sheet according to any one of claims 1 to 6, wherein the resin sheet comprises no glass fiber, or comprises glass fibers in a content thereof of 10% by volume or less based on the total amount of the resin sheet.

8. The resin sheet according to any one of claims 1 to 7, wherein the component (A1) contains one or more kinds selected from the group consisting of a styrene based elastomer, an olefin based elastomer, a urethane based elastomer, a polyester based elastomer, a polyamide based elastomer, an acrylic based elastomer, a silicone based elastomer, and derivatives thereof.

9. A laminated board comprising a cured product of the resin sheet according to any one of claims 1 to 8.

10. A metal-clad laminated board comprising a metal foil and a cured product of the resin sheet according to any one of claims 1 to 8.

11. A printed wiring board comprising the laminated board according to claim 9 or the metal-clad laminated board according to claim 10.

12. A semiconductor package comprising the printed wiring board according to claim 11 and a semiconductor device.
